# FASCICULE DE BREVET EUROPEEN

(11) **EP 0 499 169 B1**
(45) Date de publication et mention de la délivrance du brevet: **08.03.1995**
(21) Numéro de dépôt: 92102177.0
(22) Date de dépôt: 10.02.1992
(51) Int. Cl.: G01R 31/28

(54) **Système d'évaluation des performances d'un filtre électrique**
System zur Auswertung der Eigenschaften eines elektrischen Filters
System for evaluating the characteristics of an electrical filter

(30) Priorité: 13.02.1991 FR 9101667
(43) Date de publication de la demande: 19.08.1992
(73) Titulaire: ALCATEL CABLE, 92111 Clichy Cédex (FR)
(72) Inventeur: Guillard, Jacques, F-78150 Le Chesnay (FR); Girard, Christian, F-78500 Sartrouville (FR); Morin, Pierre, F-91190 Gif Sur Yvette (FR)
(74) Mandataire: Weinmiller, Jürgen

(56) Documents cités:
- JOURNAL OF PHYSICS E.SCIENTIFIC INSTRUMENTS vol. 16, no. 11, Novembre 1983,DORKING,G.B. pages 1003 - 1012; L. WEICHERT: 'The avoidance of electricinterference in instruments'
- REVUE GENERALE DE L ELECTRICITE no. 2, Février 1987, PARIS,FRANCE pages 64 -67; CHAMPIOT ET AL.: 'SENSIBILITE DES EQUIPEMENTS ELECTRONIQUES AUX DECHARGES'
- DIGEST OF TECHNICAL PAPERS; 7TH IEEE PULSED POWER CONF. ; MONTEREY,CALIF. JUNE11-14,1989. PP.372-375;WHITE ET AL.: HDR

## Description

La présente invention concerne un système d'évaluation des performances d'un filtre électrique, utilisé en particulier pour évaluer les performances des filtres d'énergie utilisés sur des cages de Faraday ou sur des enceintes faradisées.

Pour des raisons de clarté et de simplicité, on ne parlera dans la suite que des filtres d'énergie utilisés sur les cages de Faraday. Toutefois, le lecteur comprendra que cette restriction n'est en aucun cas limitative et que la présente invention porte sur l'évaluation des performances de tous types de filtres électriques.

Les filtres d'énergie, et tout particulièrement les filtres antiparasites, sont des filtres passe-bas utilisés pour la protection contre les perturbations radioélectriques de matériels se trouvant à l'intérieur ou à l'extérieur des cages de Faraday. Ils sont installés notamment au niveau des pénétrations dans la cage des câbles d'alimentation provenant par exemple du secteur (EDF ou autre) et nécessaires à faire fonctionner par exemple des matériels se trouvant à l'intérieur de cette cage (ces alimentations sont appelées réseaux d'énergie). En effet, ces pénétrations peuvent faciliter les fuites électromagnétiques vers l'extérieur. Les fuites peuvent avoir entre autres deux conséquences importantes :
- endommager les matériels à l'extérieur de la cage,
- entraîner des fuites d'informations secrètes sous forme de signaux radioélectriques pouvant être captés par des antennes étrangères (cette conséquence est préjudiciable en particulier dans le domaine militaire) : pour éviter ces fuites, on emploie des filtres électriques antiparasites dits "filtres anti-compromissions".

Les filtres antiparasites sont donc essentiels pour permettre à la cage de Faraday d'être efficace, et ils doivent pour cela atténuer les signaux dont la fréquence se situe hors de leur bande passante. Tout comme il est nécessaire de vérifier les performances du blindage de la cage, il est également nécessaire de vérifier les performances d'un filtre antiparasites. Ceci permet de vérifier si le filtre en fonctionnement remplit bien son rôle, c'est-à-dire si l'atténuation de la tension en sortie du filtre par rapport à la tension en entrée en dehors de sa bande passante est suffisamment importante pour éviter les fuites de toutes sortes.

Cette évaluation des performances est d'autant plus importante que les composants des filtres (inductances, capacités,...) vieillissent mal, s'altèrent au cours du temps et risquent alors d'affecter la protection assurée par le filtre et donc par la cage elle-même.

L'évaluation des performances de ces filtres est alors effectuée, de manière classique, lors de révisions de maintenance ayant lieu ponctuellement tous les ans ou tous les deux ans, ou bien lorsqu'une anomalie est détectée. Pour cela, il est nécessaire de débrancher le filtre du réseau énergie, de brancher à son entrée un générateur et en sortie un récepteur. On amène donc des moyens d'émission et de réception extérieurs. Le test est ensuite effectué en reconstituant la réponse du filtre pour toute la bande de fréquences, c'est-à-dire en reconstituant sa fonction de transfert.

Ces procédés classiques sont gênants et longs. En effet, pendant toute la durée du test, l'utilisateur des matériels situés à l'intérieur de la cage n'est plus alimenté en électricité et doit donc couper ses équipements. D'autre part, les moyens de test sont encombrants et peu commodes à installer.

En outre, pour reconstituer la réponse fréquencielle du filtre, il faut réaliser plusieurs essais à différentes fréquences, ce qui est fastidieux, d'autant plus que le test doit être répété pour chacun des filtres présents sur l'enceinte.

Enfin, si l'on veut afficher le résultat du test à l'intérieur de la cage pour le communiquer à l'utilisateur, il faut transmettre l'information par un câble électrique traversant la cage. Or, ce câble constitue une source de fuites supplémentaire qui nécessite encore l'utilisation d'un filtre. En pratique, on ne transmet donc jamais le résultat du test à l'utilisateur se trouvant à l'intérieur de la cage.

Le but de la présente invention est alors de réaliser un système d'évaluation des performances d'un filtre qui permette de valider sa fonction de transfert sans débrancher le réseau électrique, de manière permanente ou sur commande d'un utilisateur, et de façon simple et rapide.

La présente invention propose à cet effet un système d'évaluation des performances d'un filtre électrique installé au niveau d'une paroi d'une enceinte faradisée sur un réseau électrique d'alimentation traversant ladite paroi, comprenant :
- des moyens d'émission d'une impulsion électrique à l'entrée dudit filtre,
- des moyens de réception et de traitement du signal électrique de réponse correspondant à ladite impulsion en sortie dudit filtre,
- des moyens d'affichage du résultat obtenu après traitement dudit signal,

caractérisé en ce que ladite impulsion électrique d'entrée est couplée audit réseau électrique et transportée par ledit réseau électrique à travers ledit filtre, ladite réponse étant obtenue en sortie dudit filtre par découplage.

Selon une caractéristique importante, la réponse couplée au réseau énergie est découplée du réseau au moyen d'un filtre dont la bande passante est telle que la réponse a une fréquence appartenant à cette bande et que le réseau a une fréquence n'appartenant pas à cette bande.

En outre, les moyens d'émission peuvent être commandés par un signal optique déclenchant un générateur d'impulsions électriques. Dans ce cas, le signal optique est transmis par un câble à fibres optiques à des moyens de réception de ce signal optique et de transformation de ce signal optique en un signal électrique permettant le déclenchement du générateur d'impulsions.

Avantageusement, l'impulsion électrique d'entrée est couplée au réseau énergie par un moyen de couplage comme le coupleur directif, la sonde de courant ou la capacité directe.

Selon une autre caractéristique importante, les moyens de réception et de traitement comprennent :
- des moyens de tri électronique de la réponse afin de ne conserver que les valeurs caractéristiques, temps de montée, amplitude maximale et pseudo-fréquence, de cette réponse,
- des moyens de conversion analogique/digitale des valeurs caractéristiques ainsi obtenues,
- des moyens de comparaison de ces valeurs caractéristiques à un seuil prélablement établi.

De manière avantageuse, lorsque l'utilisateur du système se trouve à l'intérieur de l'enceinte faradisée, les moyens de réception et de traitement étant à l'extérieur de l'enceinte et les moyens d'affichage à l'intérieur, ces moyens sont reliés entre eux par un câble à fibres optiques, le résultat obtenu après traitement de la réponse étant alors transformé en signal optique pour être transporté par ce câble.

Lorsque le résultat obtenu après le traitement dépasse un seuil préalablement établi, ce résultat déclenche, au niveau des moyens d'affichage, un signal d'alerte comme par exemple une alerte visuelle ou une alerte sonore.

Il est possible d'utiliser une impulsion calibrée en durée et en amplitude.

Enfin, les moyens d'émission peuvent se trouver à l'intérieur de l'enceinte et les moyens de réception et de traitement à l'extérieur de cette enceinte.

D'autres caractéristiques et avantages de la présente invention apparaîtront dans la description suivante d'un mode de mise en oeuvre d'un système selon l'invention donnée à titre illustratif et nullement limitatif.

Dans les figures suivantes :
- la figure 1 illustre schématiquement par blocs un système selon l'invention,
- les figures 2 et 3 représentent les courbes correspondant respectivement à l'impulsion d'entrée et à la réponse à cette impulsion d'entrée.

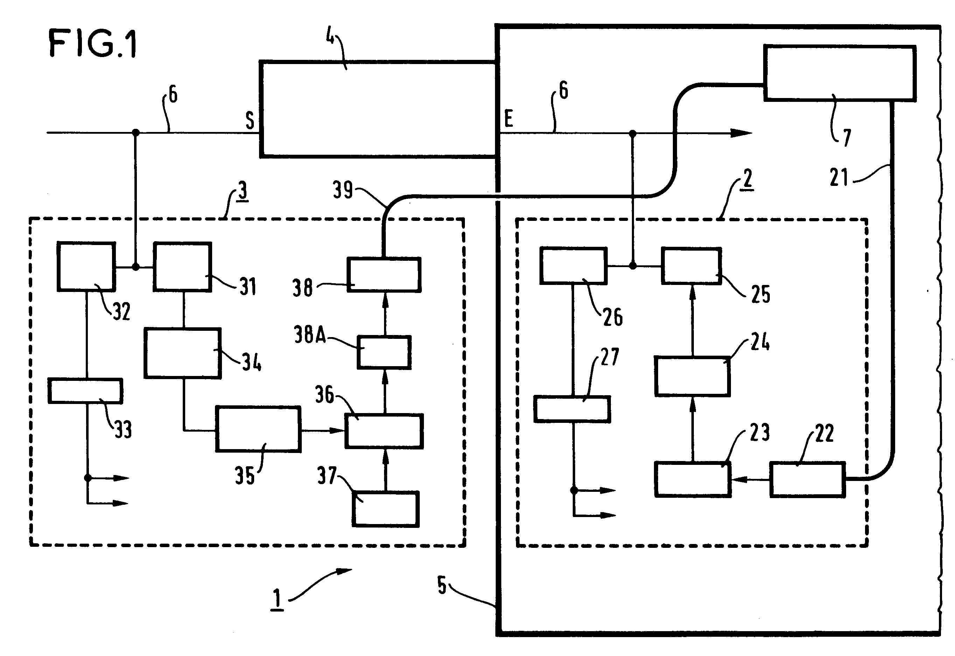

Dans la figure 1, le système 1 selon l'invention comporte deux sous-systèmes 2 et 3, le sous-système 2 étant appelé sous-système d'émission et le sous-système 3 sous-système de réception, un filtre d'énergie antiparasites 4 monté en passe-paroi sur une cage de Faraday 5, au niveau d'un réseau d'énergie 6, et un dispositif 7 de commande de test et d'affichage du résultat du test, situé dans la cage 5.

Le sous-système 2, situé dans la cage 5, est commandé par le dispositif 7 grâce auquel l'utilisateur désirant tester le filtre 4 peut déclencher quand il le souhaite, au moyen d'un bouton de commande (non représenté), un test d'évaluation des performances du filtre 4. Le dispositif 7 est relié par un câble à fibres optiques 21 à un récepteur optique 22 comprenant une photodiode. Dès réception du signal optique de commande,le récepteur 22 transforme ce signal en un signal électrique équivalent qui fait basculer un circuit de commande logique 23 et déclenche un générateur d'impulsions électriques 24.

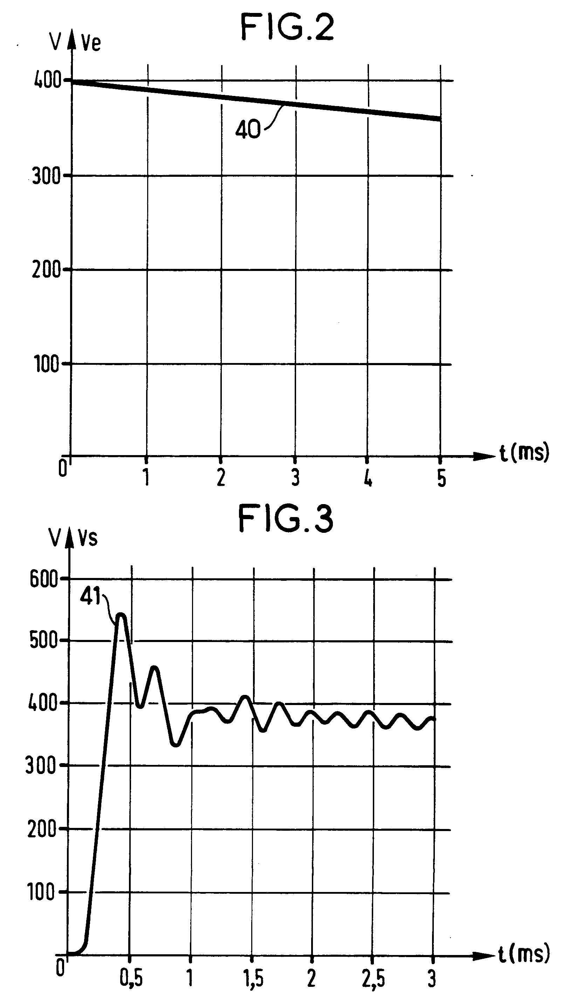

Le générateur d'impulsions 24 fournit de manière périodique une impulsion Vₑ dont la forme est donnée par la courbe 40 à la figure 2. On donnera plus loin en détail les caractéristiques de cette impulsion, et on expliquera alors les raisons de leur choix. Grâce à un coupleur directif 25, les impulsions émises par le générateur 24 sont couplées au réseau énergie 6 parvenant à l'entrée E du filtre 4. Le réseau énergie 6 alimente à la fois le matériel se trouvant dans la cage 5 et les divers circuits électriques constituant le système 1.

Or, les impulsions Vₑ fournies par le générateur 24 et couplées au réseau énergie 6, s'ajoutant à la tension d'alimentation U, risquent de causer des surtensions d'alimentation nuisibles aux circuits à alimenter. Afin d'éviter cela on filtre la tension couplée à l'aide d'un filtre passe-bas 26 situé sur le réseau énergie 6 en amont du système d'alimentation 27 des circuits. Le filtre 26 élimine la tension Vₑ et conserve la tension d'alimentation U (qui a une fréquence de 50, 60 ou 400Hz, selon les pays).

En sortie S du filtre 4, on obtient un signal somme de la tension de sortie Vₛ (voir courbe 41 à la figure 3) correspondant à la tension Vₑ atténuée par le filtre 4, et de la tension d'alimentation U pratiquement pas atténuée (le filtre 4 est un filtre passe-bas). Afin de traiter et d'analyser Vₛ,le signal issu du filtre 4 traverse un filtre passe-haut 31 destiné à éliminer la tension d'alimentation U et à découpler la tension Vₛ de la tension U.

En outre, le sous-système de réception 3, situé à l'extérieur de la cage 5, dispose encore d'un filtre passe-bas 32 ayant le même rôle que le filtre passe-bas 26 : il permet d'éliminer Vₛ et de ne fournir aux divers circuits que la tension U utile à leur alimentation 33.

Au niveau d'un dispositif de mise en forme électronique 34, le signal Vₛ subit un tri électronique permettant de déduire de la courbe 41 les valeurs des caractéristiques principales de Vₛ (on verra plus loin quelles sont ces caractéristiques). Ces valeurs sont ensuite converties en valeurs numériques par un convertisseur analogique/digital 35. Les valeurs obtenues sont comparées au niveau d'un comparateur 36 à des seuils de tolérance 37 préalablement fixés, et le signal électrique obtenu en sortie du comparateur 36 grâce à un convertisseur 38A est transformé en signal optique puis transmis au dispositif 7 grâce à un transmetteur optique 38 et à un câble à fibres optiques 39 au travers de la cage de Faraday 5.

Dans le cas où les valeurs caractéristiques dépassent les seuils de tolérance, le signal optique transmis par le câble 39 déclenche au niveau du dispositif 7 un signal visuel ou sonore indiquant à l'utilisateur par exemple que le filtre est défaillant.

Le système selon l'invention utilise donc le réseau énergie pour faire circuler l'impulsion test d'entrée et la réponse correspondante obtenue en sortie du filtre 4. Grâce au filtrage approprié effectué à l'aide des filtres passe-haut et passe-bas, les impulsions émises par le générateur 24 ne perturbent pas l'alimentation des circuits du système, et le signal de sortie correspondant est découplé de la tension d'alimentation. Ainsi, l'évaluation des performances du filtre peut être réalisée sans débrancher le réseau énergie, ce qui permet en outre au système selon l'invention d'être connecté en permanence au filtre 4 à tester.

En outre, on utilise des impulsions Vₑ émises par le générateur 24 (voir courbe 40 à la figure 2) calibrées en durée (temps de montée de l'ordre de 1 nanoseconde) et en amplitude (amplitude maximale d'environ 400V) pour obtenir un signal de sortie Vₛ (voir courbe 41 à la figure 3), caractérisé par son temps de montée (temps au bout duquel l'amplitude maximale est atteinte), son amplitude maximale et ses pseudo-fréquences d'oscillation. On montre alors, grâce aux propriétés de la Transformée de Fourier, que ces valeurs caractéristiques sont reliées aux coefficients de la fonction de transfert du filtre, eux-mêmes fonctions des paramètres du filtre, c'est-à-dire des valeurs des inductances et des capacités qui le composent.

Ainsi, en calculant les valeurs caractéristiques de la tension de sortie au niveau de la mise en forme électronique et en comparant au niveau du comparateur 36 ces valeurs à des valeurs limites tolérées, on peut déterminer si les éléments constitutifs du filtre sont ou non détériorés.

Par conséquent, grâce au traitement du signal effectué, il n'est pas nécessaire de chercher la réponse fréquentielle du filtre pour déterminer son état. Ceci évite d'avoir à tester le filtre pour un nombre important de fréquences appartenant à sa bande passante, et rend donc l'évaluation des performances relativement rapide : le résultat après émission d'une impulsion par le générateur est obtenu en quelques secondes.

Enfin, la transmission de l'information finale à l'utilisateur au moyen de fibres optiques permet de ne pas perturber l'étanchéité électromagnétique de la cage de Faraday.

Bien évidemment, l'invention n'est pas limitée au mode de mise en oeuvre qui vient d'être décrit.

Tout d'abord, le système selon l'invention peut être utilisé sur tout type de filtre électrique, utilisé ou non sur une cage de Faraday ou sur une enceinte faradisée. Par exemple, il peut être utilisé pour assurer la vérification permanente ou cyclique des filtres de type CEM (Compatibilité Electro-Magnétique) ou des filtres auxiliaires installés sur les réseaux accessoires des cages de Faraday (détection d'incendie, alarmes, coupe-circuit, signalisations diverses, téléphone, interphone,...).

D'autre part, si le moyen de couplage utilisé dans le sous-système d'émission est suffisamment directif, il n'est pas nécessaire d'utiliser un filtre passe-bas dans ce sous-système. En effet, l'impulsion émise par le générateur est alors couplée au réseau énergie vers le filtre, et ne perturbe pas l'alimentation des circuits. Toutefois, en pratique, il est préférable d'utiliser ce filtre passe-bas avec un coupleur directif, une sonde de courant ou une capacité directe.

En outre, la forme et les caractéristiques de l'impulsion sont fonctions du filtre à tester, et ne sont en aucun cas limitées à l'exemple donné plus haut.

Par ailleurs, il est possible de tester tous les filtres d'un même dispositif en injectant à leur entrée une tension en mode commun, et en récupérant le signal de sortie également en mode commun. On a alors une réponse qualitative globale permettant de connaître l'état général des circuits. Il faudra ensuite, si la réponse globale indique l'existence d'une détérioration, tester chaque filtre séparément pour déterminer le ou lesquels ont des performances dégradées.

Le système selon l'invention peut permettre également d'obtenir l'affichage de la tension Vₛ et de ses valeurs caractéristiques. Un relevé du filtre est alors fourni par le système selon l'invention.

Enfin, l'alimentation du système selon l'invention peut être réalisée soit en courant, soit en tension.

## Revendications

1. Système d'évaluation des performances d'un filtre électrique (4) installé au niveau d'une paroi d'une enceinte faradisée (5) sur un réseau électrique d'alimentation (6) traversant ladite paroi, comprenant :
- des moyens (2) d'émission d'une impulsion électrique à l'entrée (E) dudit filtre (4),
- des moyens (3) de réception et de traitement du signal électrique de réponse correspondant à ladite impulsion en sortie (S) dudit filtre,
- des moyens (7) d'affichage du résultat obtenu après traitement dudit signal,
caractérisé en ce que ladite impulsion électrique d'entrée est couplée audit réseau électrique (6) et transportée par ledit réseau électrique (6) à travers ledit filtre (4), ladite réponse étant obtenue en sortie (5) dudit filtre (4) par découplage.

2. Système selon la revendication 1, caractérisé en ce que ladite réponse couplée audit réseau énergie (6) est découplée dudit réseau (6) au moyen d'un filtre (31) dont la bande passante est telle que ladite réponse a une fréquence appartenant à ladite bande et que ledit réseau (6) a une fréquence n'appartenant pas à ladite bande.

3. Système selon l'une des revendications 1 et 2, caractérisé en ce que lesdits moyens (2) d'émission sont commandés par un signal optique déclenchant un générateur d'impulsions électriques (24).

4. Système selon la revendication 3, caractérisé en ce que ledit signal optique est transmis par un câble à fibres optiques (21) à des moyens (22) de réception dudit signal optique et de transformation dudit signal optique en un signal électrique permettant le déclenchement dudit générateur d'impulsions (24).

5. Système selon l'une des revendications 1 à 4, caractérisé en ce que ladite impulsion électrique d'entrée est couplée audit réseau énergie (6) par un moyen de couplage (25) choisi parmi un coupleur directif, une sonde de courant et une capacité directe.

6. Système selon l'une des revendications 1 à 5, caractérisé en ce que lesdits moyens (3) de réception et de traitement comprennent :
- des moyens (34) de tri électronique de ladite réponse afin de ne conserver que les valeurs caractéristiques, temps de montée, amplitude maximale et pseudo-fréquences, de ladite réponse,
- des moyens (35) de conversion analogique/digitale desdites valeurs caractéristiques ainsi obtenues,
- des moyens (36) de comparaison desdites valeurs caractéristiques obtenues à un seuil (37) prélablement établi.

7. Système selon l'une des revendications 1 à 6, caractérisé en ce que, lorsque l'utilisateur dudit système (1) se trouve à l'intérieur de ladite enceinte faradisée (5), lesdits moyens (3) de réception et de traitement étant à l'extérieur de ladite enceinte et lesdits moyens (7) d'affichage à l'intérieur, ces moyens sont reliés entre eux par un câble à fibres optiques (39), le résultat obtenu après traitement de ladite réponse étant alors transformé en signal optique pour être transporté par ledit câble (39).

8. Système selon l'une des revendications 1 à 7, caractérisé en ce que, lorsque le résultat obtenu après ledit traitement dépasse un seuil (37) préalablement établi, ledit résultat déclenche, au niveau desdits moyens d'affichage (7), un signal d'alerte choisi parmi une alerte visuelle et une alerte sonore.

9. Système selon l'une des revendications 1 à 8, caractérisé en ce que ladite impulsion est calibrée en durée et en amplitude.

10. Système selon l'une des revendications 1 à 9, caractérisé en ce que lesdits moyens (2) d'émission se trouvent à l'intérieur de ladite enceinte (5) et en ce que lesdits moyens (3) de réception et de traitement se trouvent à l'extérieur de ladite enceinte (5).

## Patentansprüche

1. System zur Bewertung der Leistungsfähigkeit eines elektrischen Filters (4), das im Bereich einer Wand eines als Faradaykäfig ausgebildeten Gehäuses (5) auf einem elektrischen Stromversorgungsnetz (6) installiert ist, das die Wand durchquert,
- mit Mitteln (2) zum Anlegen eines elektrischen Impulses an den Eingang (E) des Filters (4),
- mit Mitteln (3) zum Empfangen und Verarbeiten des elektrischen Antwortsignals auf diesen Impuls am Ausgang (S) des Filters,
- und mit Mitteln (7) zum Anzeigen des nach der Verarbeitung des Signals erhaltenen Ergebnisses,
dadurch gekennzeichnet, daß der elektrische Eingangsimpuls an das elektrische Netz (6) gekoppelt und vom elektrischen Netz (6) durch das Filter (4) übertragen wird, wobei die Antwort am Ausgang (5) des Filters (4) durch Entkopplung erhalten wird.

2. System nach Anspruch 1, dadurch gekennzeichnet, daß die an das Energienetz (6) gekoppelte Antwort vom Netz (6) mit Hilfe eines Filters (31) entkoppelt wird, dessen Durchlaßbereich so beschaffen ist, daß die Antwort eine Frequenz aufweist, die zum Durchlaßbereich gehört, während die Frequenz des Netzes (6) nicht zu diesem Durchlaßbereich gehört.

3. System nach einem der Ansprüche 1 und 2, dadurch gekennzeichnet, daß die Mittel (2) zum Anlegen eines Impulses durch ein optisches Signal gesteuert werden, das einen elektrischen Impulsgenerator (24) auslöst.

4. System nach Anspruch 3, dadurch gekennzeichnet, daß das optische Signal über ein Lichtfaserkabel (21) an Mittel (22) zum Empfang dieses optischen Signals und zum Umwandeln des optischen Signals in ein elektrische Signal übertragen wird, das das Auslösen des Impulsgenerators (24) ermöglicht.

5. System nach einem der Ansprüche 1 bis 4, dadurch gekennzeichnet, daß der elektrische Eingangsimpuls in das Energienetz (6) durch ein Kopplungsmittel (25) eingekoppelt wird, das unter einem Richtkoppler, einem Stromsensor und einer aktiven Kapazität gewählt ist.

6. System nach einem der Ansprüche 1 bis 5, dadurch gekennzeichnet, daß die Empfangs- und Verarbeitungsmittel (3) aufweisen
- Mittel (34) zur elektronischen Selektion der Antwort, um nur die charakteristischen Werte, Anstiegsdauer, maximale Amplitude und Pseudofrequenz dieser Antwort zu speichern,
- Mittel (35) zur A/D-Umwandlung der so erhaltenen charakteristischen Werte,
- Mittel (36) zum Vergleichen dieser erhaltenen charakteristischen Werte mit einem zuvor erstellten Schwellenwert (37).

7. System nach einem der Ansprüche 1 bis 6, dadurch gekennzeichnet, daß, wenn sich der Benutzer des Systems (1) im Inneren des als Faradaykäfig ausgebildeten Gehäuses (5) befindet, während die Empfangs- und Verarbeitungsmittel (3) außerhalb des Gehäuses und die Anzeigemittel (7) innerhalb desselben liegen, diese Mittel vorzugsweise untereinander durch ein Lichtfaserkabel (39) verbunden sind, wobei dann das nach der Verarbeitung der Antwort erhaltene Ergebnis in ein optisches Signal umgewandelt wird, um durch dieses Kabel (39) transportiert zu werden.

8. System nach einem der Ansprüche 1 bis 7, dadurch gekennzeichnet, daß, wenn das nach der Verarbeitung erhaltene Ergebnis einen vorher erstellten Schwellenwert (37) überschreitet, das Ergebnis in den Anzeigemitteln (7) ein optisches oder akustisches Warnsignal auslöst.

9. System nach einem der Ansprüche 1 bis 8, dadurch gekennzeichnet, daß der Impuls nach Dauer und Amplitude kalibriert ist.

10. System nach einem der Ansprüche 1 bis 9, dadurch gekennzeichnet, daß sich die Mittel (22) zum Anlegen eines Impulses im Inneren des Gehäuses (5) befinden, und daß sich die Empfangs- und Verarbeitungsmittel (3) außerhalb des Gehäuses (5) befinden.

## Claims

1. A system for evaluating the performance of an electrical filter (4) installed on an electrical power supply network (3) passing through the wall of a Faraday enclosure (5), said wall comprising:
transmit means (2) for transmitting an inlet electrical pulse to the inlet (E) of said filter (4);
receive and processing means (3) for receiving and processing the response electrical signal at the outlet (S) of said filter and corresponding to said pulse; and
display means (7) for displaying the results obtained after processing said signal;
the system being characterized in that said inlet electrical pulse is coupled to said power supply network (6) and is conveyed thereby through said filter (4), said response being obtained from the outlet (S) of said filter (4) by decoupling.

2. A system according to claim 1, characterized in that said response coupled to said power supply network (6) is decoupled from said network (6) by means of a filter (31) whose passband is such that said response has a frequency belonging to said passband, while said network (6) has a frequency that does not belong to said passband.

3. A system according to claim 1 or 2, characterized in that transmit means (2) are controlled by an optical signal triggering an electrical pulse generator (24).

4. A system according to claim 3, characterized in that said optical signal is transmitted by an optical fiber cable (21) to means (22) for receiving said optical signal and for transforming said optical signal into an electrical signal enabling said pulse generator (24) to be triggered.

5. A system according to any one of claims 1 to 4, characterized in that said inlet electrical pulse is coupled to said power supply network (6) by coupling means (25) selected from: a directional coupler, a current probe, and a directly-connected capacitor.

6. A system according to any one of claims 1 to 5, characterized in that said receive and processing means (3) comprise:
electronic sorting means (34) for sorting said response to conserve only characteristic values of said response: rise time, maximum amplitude, and frequency components;
analog-to-digital converter means for converting said characteristic values obtained in this way;
comparator means (36) for comparing said characteristic values as obtained with corresponding pre-established thresholds (37).

7. A system according to any one of claims 1 to 6, characterized in that when the user of said system (1) is inside said Faraday-screened enclosure (5), and said receive and processing means (3) are outside said enclosure, while said display means (7) are inside, said means are interconnected by an optical fiber cable (39), with the result obtained after processing of said response then being transformed into an optical signal to be conveyed by said cable (39).

8. A system according to any one of claims 1 to 7, characterized in that when the result obtained after said processing exceeds a pre-established threshold (37), said result triggers a warning signal at said display means (7), the warning signal being selected from a visible warning and an audible warning.

9. A system according to any one of claims 1 to 8, characterized in that said pulse is calibrated in duration and in amplitude.

10. A system according to any one of claims 1 to 9, characterized in that said transmit means (2) are inside said enclosure (5) and in that said receive and processing means (3) are outside said enclosure (5).
